# EUROPÄISCHE PATENTSCHRIFT

(11) **EP 1 754 399 B1**
(45) Veröffentlichungstag und Bekanntmachung des Hinweises auf die Patenterteilung: **30.01.2008**
(21) Anmeldenummer: 05729754.1
(22) Anmeldetag: 02.03.2005
(51) Int. Cl.: H05K 3/38, H05K 3/00, H05K 1/03

(54) **VERFAHREN ZUR HERSTELLUNG VON DURCHKONTAKTIERUNGEN BEI LEITERPLATTENGEBILDEN**
METHOD FOR PRODUCING TRANSVERSE CONNECTIONS IN PRINTED CIRCUIT BOARD SETS
PROCEDE POUR PRODUIRE DES CONNEXIONS TRANSVERSALES DANS DES ENSEMBLES DE CARTES A CIRCUITS IMPRIMES

(30) Priorität: 29.04.2004 DE 102004021063
(43) Veröffentlichungstag der Anmeldung: 21.02.2007
(73) Patentinhaber: Siemens Home and Office Communication Devices GmbH & Co. KG, 81379 München (DE)
(72) Erfinder: BUSCH, Georg, 48683 Ahaus (DE)
(74) Vertreter: Maier, Daniel Oliver
(86) Internationale Anmeldenummer: PCT/EP2005/050918
(87) Internationale Veröffentlichungsnummer: WO 2005/107348

(56) Entgegenhaltungen:
- WO-A-20/04015161
- US-A- 6 153 060
- US-A1- 2002 000 370
- US-A1- 2002 162 218

## Beschreibung

Die Erfindung betrifft ein Verfahren zur Herstellung von Durchkontaktierungen gemäß dem Oberbegriff des Anspruchs 1.

Bei Verfahren für die Herstellung von zwei- oder mehrlagigen Leiterplattengebilden stellen Durchkontaktierungen im Allgemeinen und insbesondere Mikro-Durchkontaktierungen auf kleinstem Raum mit einem Pad-Durchmesser kleiner 200 µm ein Problem dar. Nach derzeitigem Technologiestand können beispielsweise Mikro-Vias mit einem Lochdurchmesser von 75 bis 100 µm und einem Pad-Durchmesser von 250 bis 300 µm gefertigt werden.

Entsprechende Angaben gehen aus den Unterlagen beispielsweise der Firma P.C.M. GmbH, Hattsteiner Allee 17, 61250 Usingen, URL: http://www.p-m-c.de/Produkte/Standardleiterplatten/techrdllp_d.htm hervor.

Daneben ist aus dem Dokument WO 2004/015161 A1 ein Verfahren und eine Anordnung zur Bearbeitung von Trägermaterial durch Schwerionenbestrahlung und nachfolgendem Ätzprozess bekannt, die dazu verwendet werden, die Oberfläche eines Trägermittels eines Leiterplattengebildes bzw. des Trägermaterials des Leiterplattengebildes aufzurauen, damit eine nachfolgend aufzubringende Kupferschicht auf der entsprechend bearbeiteten Oberfläche des Trägermittels bzw. des Trägermaterials sicher dort hält.

Das Aufrauen der Oberfläche ist insbesondere dann wichtig, wenn die Kupferschicht kleberlos auf das Trägermittel bzw. Trägermaterial aufgebracht wird und wenn es sich bei dem Trägermittel bzw. Trägermaterial um Kunststoff wie zum Beispiel Polyimid handelt. Polyimid (PI) wird für hochwertige Leiterplattengebilden verwendet, die biegbar, das heißt flexibel sind. Andere Beispiele für solche Trägermittel sind Polyethylennaphtalat (PEN) oder Polyester (PET). Für starre Leiterplattengebilden kann als Trägermittel beispielsweise CEM1, FR2 oder FR4 eingesetzt werden.

Bei bisherigen Herstellungsprozessen für die Herstellung von Leiterplattengebilden werden zum Zeitpunkt der Realisierung der Durchkontaktierungen Trägermittel verwendet, die schon kupferbeschichtet sind. Dies hat zur Folge, dass beim Herstellen der elektrischen Durchkontaktierung zumindest an einigen Stellen eine weitere Kupferschichtlage aufgebracht wird, durch die die Dicke des letztlich erhaltenen Leiterplattengebildes erhöht wird. Außerdem ist der Aufwand für das Aufbringen der ersten Kupferschichtlage quasi redundant erfolgt. Ein weiterer Nachteil ist, dass die insgesamt erhaltene dickere Kupferschicht nur eine gröbere Leiterbahnstruktur als eine dünnere Gesamtkupferschicht zulässt. Im übrigen soll versucht werden, eine weitere Reduzierung des Platzbedarfs für die Durchkontaktierungen zu erreichen, damit beispielsweise mehr als bisher auf einer vorgegebenen Fläche des Leiterplattengebildes untergebracht werden können.

Aus dem Dokument US-A-6 153 060 ist ein Verfahren bekannt, bei dem Durchkontaktierungen durch Laserbohren in einem Substrat, wie zum Beispiel Polyimid, hergestellt werden. Bei der Herstellung dieser Durchkontaktierungen wird ein kohlenstoffhaltiger Ring (carbonaceous ring oder "laser slag") erzeugt, der anschließend mittels Ionen-Ätzprozess (ion etching) entfernt wird.

Aufgabe der vorliegenden Erfindung ist es somit, ein Verfahren zur Herstellung von Leiterplattengebilden der eingangs genannten Art anzugeben, das einen vereinfachten Herstellungsprozess hat, das die Herstellung kleinster Durchkontaktierungen ermöglicht, und das auch bei Leiterplattengebilden verwendbar ist, die kleberlos hergestellt werden und flexibel sind.

Diese Aufgabe wird erfindungsgemäß durch ein Verfahren gelöst, das die im kennzeichnenden Teil des Anspruchs 1 angegebenen Verfahrensschritte aufweist.

Danach werden zum Zeitpunkt der Herstellung der Durchkontaktierungen Trägermittel verwendet, die noch keine Kupferschicht auf den Oberflächen haben. Damit entfallen bis zu diesem Zeitpunkt bereits solche Herstellungsschritte, die notwendig sind, um diese Schichten auf das Trägermittel zu montieren. Damit wird das Gesamtverfahren zur Herstellung des Leiterplattengebildes letztlich vereinfacht.

Vor dem Montieren irgendwelcher Schichten wird an für Durchkontaktierungen vorgesehenen Stellen des späteren Leiterplattengebildes mit einem Lochherstellungsverfahren zum Herstellen jeweils wenigstens eines einzigen Lochs an einer jeweils betreffenden Stelle wenigstens jeweils ein einziges Loch erzeugt.

Als Lochherstellungsverfahren kann beispielsweise das Verfahren des Bohrens, des Laserns oder des Durchschießens von Schwerionen eingesetzt werden. Letzteres hat insbesondere den Vorteil, dass kleinste Durchkontaktierungen realisiert werden können.

Mit Hilfe eines sich anschließenden Ätzprozesses können die fabrizierten Löcher auf ein gewünschtes Maß aufgeätzt werden. Dabei werden, falls das verwendete Lochherstellungsverfahren es mit sich bringt, dass an einer Stelle gleichzeitig mehr als ein einziges Loch nebeneinander erzeugt werden, wie das beispielsweise beim Beschuss von Schwerionen möglich ist, nah beieinander liegende Löcher zu einem einzigen Loch gewünschter Größe zusammengeschmolzen. Ein solches Endloch hat dann beispielsweise einen Lochdurchmesser von 1 bis 3 µm, was derzeit das mögliche Kleinstloch für eine Durchkontaktierung darstellt.

Erst im nachfolgenden Verfahrensschritt erfolgt die Kupferkaschierung der Oberflächen des Trägermittels bzw. des Trägermaterials des Leiterplattengebildes. Dabei wird gleichzeitig die elektrische Durchkontaktierung zwischen den Kupferkaschierungen durch die im vorherigen Verfahrensschritt hergestellten Löcher bewerkstelligt.

Da bisher noch keine Kupferschichten vorhanden waren sind die Dicken der Kupferkaschierungen minimal. Es lassen sich somit mit diesen Kupferkaschierungen feinste Leiterbahnstrukturen herstellen.

Außerdem haben die kleinen Durchmesser der Durchkontaktierungen den Vorteil, dass diese beim Herstellen der elektrischen Durchkontaktierungen vollständig mit Kupfer gefüllt werden. Dies ist vorteilhaft für eine mögliche maximale Stromdichte, die über diese Durchkontaktierungen fließen kann, und ist vorteilhaft im Hinblick auf eine plane Oberfläche des Trägermittels. Es müssen daher die Durchkontaktierungen nicht in einem weiteren Verfahrensschritt extra befüllt werden, um eine plane Oberfläche zu erhalten.

Schließlich können die weiteren, an sich bekannten Verfahrensschritte durchgeführt werden, um letztlich ein vollständiges gewünschtes Leiterplattengebilde zu erhalten.

Da die Durchkontaktierungen sehr klein sind, können auf einer vorgegebenen Fläche des Trägermittels bzw. des Leiterplattengebildes entsprechend vermehrt Durchkontaktierungen vorgesehen werden. Dies ist insbesondere von Vorteil, wenn das Leiterplattengebilde beispielsweise für Displays verwendet werden soll, bei denen es notwendig ist eine, und das in stetig steigender Zahl, Vielzahl von Ansteuerungspunkten ansteuern zu können.

Vorteilhafte Ausgestaltungen der Erfindung sind Gegenstand von Unteransprüchen.

Danach kann als Lochherstellungsverfahren, wie oben schon angesprochen, der Schwerionenbeschuss angewendet werden. Damit lassen sich, wie oben schon gesagt, kleinste Durchkontaktierungen realisieren. Werden keine so kleinen Durchkontaktierungen benötigt, können die Löcher auch mittels einer Lasermethode erzeugt werden. Können die Durchkontaktierungen noch gröber sein, können die Löcher auch mittels eines herkömmlichen Bohrverfahrens bewerkstelligt werden.

Weiter vorteilhaft ist die Möglichkeit der Verwendung von flexiblen Materialien wie Polyimid als Trägermittel, weil damit flexible Leiterplattengebilden hergestellt werden können. Dies sogar mit kleinsten Durchkontaktierungen und feinsten Leiterbahnstrukturen.

Ein anderer Vorteil ist, dass der Verfahrensschritt des Aufrauens der Oberfläche des Trägermittels zur Sicherstellung der Haftfestigkeit bezüglich der Kupferkaschierungen nicht vorab erfolgen muss, wenn zur Lochbildung für die Durchkontaktierungen die Beschussmethode mit den Schwerionen gewählt wird. Die Beschussmethode lässt sich neben der Herstellung der Löcher für die Durchkontaktierungen bei entsprechender Steuerung der Schwerionenabstrahlung gleichzeitig zum Aufrauen der Oberflächen des Trägermittels verwenden. An Stellen, an denen nur ein Aufrauen der Oberfläche des Trägermittels gewünscht wird, wird entsprechend weniger intensiv die Schwerionenabstrahlung eingestellt. An Stellen, an denen Durchgangslöcher gewünscht sind, erfolgt ein entsprechend verstärkter Beschuss, so dass die Schwerionen an diesen Stellen durch die ganze Dicke des Trägermittels dringen. Damit werden Kosten und Fertigungszeiten eingespart.

Mit der Möglichkeit des Aufrauens der Oberflächen des Trägermittels ist der Vorteil verbunden, dass das Leiterplattengebilde kleberlos realisiert werden kann.

## Patentansprüche

1. Verfahren zur Herstellung von Durchkontaktierungen bei Leiterplattengebilden, die aus einem Trägermittel bestehen, auf dem letztlich alle weiteren Mittel angeordnet werden, mit denen im Zusammenwirken mit dem Trägermittel das Leiterplattengebilde realisiert wird, **dadurch gekennzeichnet, dass** ausschließlich das Trägermittel selbst vor dem Aufbringen der weiteren Mittel an für Durchkontaktierungen vorgesehenen Stellen des späteren Leiterplattengebildes mit einem Lochherstellungsverfahren zum Herstellen jeweils wenigstens eines einzigen Lochs an einer jeweils betreffenden Stelle beaufschlagt wird, dass nachfolgend ein Ätzprozess durchgeführt wird mit dem das oder die an den jeweiligen mit dem Lochherstellungsverfahren beaufschlagten Stellen erzeugte Loch oder Löcher jeweils insgesamt jeweils zu einem einzigen gemeinsamen Loch einer gewünschten Gesamtgröße aufgeätzt wird oder werden, dass ein Kupferkaschierungsprozess durchgeführt wird bei dem eine vorhandene Ober- und Unterseite des Trägermittels, auf denen die weitere Anordnung der weiteren Mittel zur Bildung des Leiterplattengebildes in späteren Schritten vorgenommen wird, kupferkaschiert und gleichzeitig die elektrisch leitenden Durchkontaktierungen durch die im vorherigen Verfahrensschritt erzeugten Löcher fabriziert werden, und dass anschließend alle weiteren Schritte zur Realisierung des vollständigen Leiterplattengebildes realisiert werden.

2. Verfahren nach Anspruch 1, **dadurch gekennzeichnet, dass** bei dem Lochherstellungsverfahren ein Schwerionenbeschuss durchgeführt wird.

3. Verfahren nach Anspruch 1 oder 2, **dadurch gekennzeichnet, dass** als Trägermittel eine Polyimidfolie verwendet wird.

4. Verfahren nach Anspruch 2 oder 3, **dadurch gekennzeichnet, dass** beim Schwerionenbeschuss gleichzeitig ein Aufrauen der dem Beschuss zugewandten Seite der Oberfläche des Trägermittels mit einem jeweils entsprechend angepassten Schwerionenbeschuss durchgeführt wird.

5. Verfahren nach einem der vorherigen Ansprüche, **dadurch gekennzeichnet, dass** das Leiterplattengebilde als kleberloses Leiterplattengebilde realisiert wird.

## Claims

1. Method for producing transverse connections in printed circuit board sets consisting of a support element, on which ultimately all further elements are arranged, with which the printed circuit board set is realised in interaction with the support element, **characterised in that** only the support element itself is subjected to a hole production method to produce in each case at least one single hole at a relevant point in each case before the application of the further elements at points on the subsequent printed circuit board set which are intended for transverse connections, that subsequently an etching process is carried out with which the hole or holes created at the points subjected to the hole production method in each case is or are etched in each case overall to produce in each case a single common hole of a desired overall size, that a copper coating process is carried out in which an existing top or bottom side of the support element on which the further arrangement of the further elements in order to form the printed circuit board set is undertaken in subsequent stages is coated with copper and simultaneously the electrically conducting transverse connections are fabricated through the holes created in the previous method step, and that subsequently all further steps to realise the complete printed circuit board set are realised.

2. Method according to claim 1, **characterised in that** a heavy ion bombardment is performed in the hole production method.

3. Method according to claim 1 or 2, **characterised in that** a polyimide membrane is used as a support element.

4. Method according to claim 2 or 3, **characterised in that** simultaneously during the heavy ion bombardment a roughening of the side of the surface of the support element facing the bombardment is carried out using a heavy ion bombardment which is correspondingly adapted in each case.

5. Method according to one of the preceding claims, **characterised in that** the printed circuit board set is realised as an adhesive-free printed circuit board set.

## Revendications

1. Procédé pour fabriquer des connexions transversales dans le cas d'ensembles de cartes à circuits imprimés, comprenant un moyen support, sur lequel sont disposés en fin de compte tous les autres moyens, avec lesquels l'ensemble de cartes à circuits imprimés est réalisé en coopération avec le moyen support, **caractérisé en ce que** seul le moyen support est sollicité, même avant l'application des autres moyens en des emplacements prévus pour des connexions transversales du futur ensemble de cartes à circuits imprimés, avec un procédé de fabrication de trou pour la fabrication de respectivement au moins un unique trou en un emplacement concerné, **en ce qu'**ensuite on applique un processus de décapage avec lequel le trou ou les trous généré(s) aux emplacements respectifs sollicités avec le procédé de fabrication de trou sont décapés à chaque fois globalement pour former un unique trou commun d'une grandeur globale souhaitée, **en ce qu'**un processus de revêtement de cuivre est mis en oeuvre dans lequel un côté supérieur et un côté inférieur existants du moyen support, sur lesquels on effectue l'autre agencement des autres moyens pour former l'ensemble de cartes à circuits imprimés dans des étapes ultérieures, sont recouverts de cuivre et simultanément les connexions transversales électroconductrices sont fabriquées par les trous générés dans l'étape de procédé précédente, et **en ce qu'**ensuite toutes les autres étapes pour réaliser l'ensemble complet de cartes à circuits imprimés sont réalisées.

2. Procédé selon la revendication 1, **caractérisé en ce qu'**un bombardement avec des ions lourds est effectué avec le procédé de fabrication de trou.

3. Procédé selon la revendication 1 ou 2, **caractérisé en ce qu'**un film de polyimide est utilisé comme moyen support.

4. Procédé selon la revendication 2 ou 3, **caractérisé en ce que**, avec le bombardement avec des ions lourds, on effectue simultanément un grattage du côté, associé au bombardement, de la surface du moyen support avec un bombardement avec des ions lourds adapté en conséquence.

5. Procédé selon l'une quelconque des revendications précédentes, **caractérisé en ce que** l'ensemble de cartes à circuits imprimés est réalisé sous forme d'ensemble de carte à circuits imprimés sans colle.
